**Europäisches Patentamt**

**European Patent Office**

**Office européen des brevets**

(11) Veröffentlichungsnummer : **0 220 404 B1**

(12) # EUROPÄISCHE PATENTSCHRIFT

(45) Veröffentlichungstag der Patentschrift :
06.02.91 Patentblatt 91/06

(51) Int. Cl.$^5$ : **H01L 21/302, H01L 21/461**

(21) Anmeldenummer : **86111168.0**

(22) Anmeldetag : **12.08.86**

(54) Verfahren zur Begrenzung von Ausbrüchen beim Sägen einer Halbleiterscheibe.

(30) Priorität : **30.09.85 DE 3534894**

(43) Veröffentlichungstag der Anmeldung :
**06.05.87 Patentblatt 87/19**

(45) Bekanntmachung des Hinweises auf die
Patenterteilung :
**06.02.91 Patentblatt 91/06**

(84) Benannte Vertragsstaaten :
**DE FR GB**

(56) Entgegenhaltungen :
**EP-A- 0 032 801**
**FR-A- 1 480 433**
**FR-A- 2 382 097**
**US-A- 4 033 027**

(73) Patentinhaber : **Siemens Aktiengesellschaft**
**Wittelsbacherplatz 2**
**D-8000 München 2 (DE)**

(72) Erfinder : **Arlt, Manfred, Dipl.-Phys.**
**Schützenheimstrasse 32/c**
**D-8400 Regensburg (DE)**
Erfinder : **Dathe, Joachim, Dipl.-Phys.**
**Schleissheimerstrasse 276**
**D-8000 München 40 (DE)**

EP 0 220 404 B1

## Beschreibung

Die Erfindung betrifft ein Verfahren zur Begrenzung von Ausbrüchen beim Sägen einer Halbleiterscheibe ; EP-A-0 032 801 beschreibt ein solches Verfahren, bei dem eine Schicht -z.B. thermisches Oxid-neben dem Sägebereich aufgebracht wird.

Beim Zersägen von Halbleiterscheiben in Einzelchips entstehen an der Sägekante der Halbleiterscheibenvorderseite sogenannte Muschelausbrüche (Chippage). Diese Muschelausbrüche entstehen unabhängig von der Sägetiefe bezüglich der Halbleiterscheibe und entstehen abhängig von verschiedenen Sägeparametern wie z.B. Sägeblattqualität, Sägeblattalter, Sägegeschwindigkeit, und entstehen je abhängig von Parametern der Halbleiterscheibe wie z.B. Dotierung des Halbleiters im Sägebereich, Art und Zahl der Oberflächenschichten usw.

Diese als "Chippage" bezeichneten flachen Halbleiter-Aussplitterungen können die Bauelementequalität beeinflussen, wenn die "Chippage"-Breite so groß ist, daß aktive Chip-Bereiche wie z.B. ein Guardring oder ein PN-Übergang zerstört werden.

Bisher wurde versucht, durch entsprechend großen Abstand zwischen aktivem Bereich eines einzelnen Chips und dem bei maximal auftretendem "Chippage" zerstörten Gebiet die Qualitätsminderung der Einzelchips zu vermeiden, da außerhalb der sichtbaren Bruchzone im Bereich des "Chippage" keine Kristallzerstörung bezüglich der Einzelchips durch unsichtbare "Mikrorisse" mittels einer anisotroppen Ätzung (z.B. "Sirtl-Etch") nachweisbar sind.

Da im Zuge der Miniaturisierung von Halbleiterbauelementen immer mehr versucht wird, Platz zu sparen, und da daher der Platz auf der Oberfläche einer Halbleiterscheibe kostbar ist, liegt der vorliegenden Erfindung die Aufgabe zugrunde, die Sägespurbreite zu reduzieren, ohne die Qualität bzw. die Ausbeute der aus einer Halbleiterscheibe durch Sägen erhaltenen Einzelchips zu reduzieren.

Diese Aufgabe wird erfindungsgemäß durch ein Verfahren nach dem Anspruch 1 gelöst.

Vorteile der Erfindung werden im folgenden zwar anhand von Silicium und von Siliciumverbindungen erläutert. Die Erfindung ist jedoch nicht auf eine Anwendung auf Siliciumhalbleiterscheiben oder auf Siliciumverbindungen beschränkt. Vielmehr kann jede Halbleiterscheibe in Verbindung mit chemischen Siliciumverbindungen oder in Verbindung mit anderen dielektrischen Schichten mit einem Verfahren nach der Erfindung behandelt werden.

Bei der Erfindung werden beispielsweise die mechanischen Spannungen, die beispielsweise bei der thermischen Oxidation von Silicium im Bereich der daraus resultierenden Grenzfläche zwischen Silicium und Siliciumdioxid entstehen, ausgenutzt, um das Ausbrechen des Siliciums beim Sägen einer Halbleiterscheibe zu stoppen. Nach dem Abkühlen von der Oxidationstemperatur auf Raumtemperatur um einen bestimmten Temperaturunterschied $\Delta T$ steht das auf der Siliciumoberfläche gewachsene thermische Siliciumdioxid unter erheblicher Kompressionsspannung und steht das Silicium in der Nähe der Grenzfläche zum Siliciumdioxid unter Zugspannung, was durch die unterschiedlichen linearen Ausdehnungskoeffizienten von Silicium und Siliciumdioxid verursacht ist. Silicium hat einen linearen Ausdehnungskoeffizienten von $2.5 \times 10^{-6}/°C$. Der lineare Ausdehnungskoeffizient von Siliciumdioxid ($SiO_2$) beträgt $0.5 \times 10^{-6}/°C$.

Die Kräfte im Silicium sind umso größer, je größer der Temperaturunterschied $\Delta T$ zwischen der Oxidationstemperatur und der Raumtemperatur ist und je dicker das Siliciumdioxid ist. Überschreitet die Zugkraft, die das Siliciumdioxid an der Grenzfläche zum Silicium auf das Silicium ausübt, einen kritischen Wert, dann tritt im Silicium ein Spannungsausgleich in Form von flachen Kristallversetzungen ein. Diese flachen Kristallersetzungen werden "Saucer Etch Pits" genannt.

Die Erfindung verwendet beispielsweise ein Oxid, bei dem an der Grenzfläche zum Silicium im Silicium dieser Spannungsausgleich nicht stattgefunden hat. Wird aus dem auf die Halbleiteroberfläche aufgebrachten Oxid ein den aktiven Bereich eines Halbleiter-Bauelement-Einzelchips umgebender Rahmen geätzt, der eine Breite in der Größenordnung von $1\mu m$, vorteilhafterweise eine Breite größer oder gleich $5\mu m$ und eine Oxiddicke in der Größenordnung $0,1\mu m$, vorteilhafterweise größer oder gleich $0,1\mu m$ aufweist, so verhindert insbesondere das in der Nähe der Oxidkanten dieses den aktiven Bereich umgebenden Rahmens an der Siliciumoberfläche im Sägebereich zwischen zwei Einzelchips entstehende symmetrische Zugspannungsfeld das Ausbrechen des Siliciums. Aus diesem Grund kann man diesen den aktiven Bereich des Einzelchips umgebenden Rahmen als "Chippage-Stopper" bezeichnen.

Ausgestaltungen und Vorteile der Erfindung sind in den Unteransprüchen, der Beschreibung und der Zeichnung dargestellt.

Das Prinzip der Erfindung wird anhand der Zeichnung näher erläutert.

Fig. 1 zeigt eine Draufsicht auf einen Einzelchip mit einem erfindungsgemäßen Rahmen.

Fig. 2 zeigt einen schematischen Querschnitt durch ein Ausführungsbeispiel mit einem erfindungsgemäßen Rahmen.

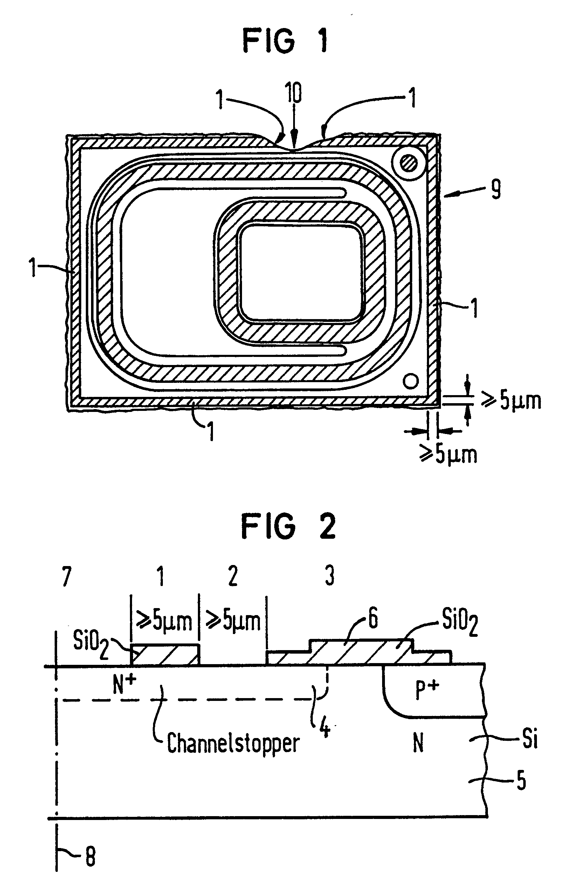

Fig. 1 zeigt eine Draufsicht auf einen gesägten Einzelchip, der einen NPN-Transistor Diode darstellt. Die Kollektor-Basis-Diode besitzt einen Rahmen 1 aus Siliciumdioxid, das bei erhöhter Temperatur auf das Siliciumsubstrat 5 aufgebracht worden ist. Wie Fig. 1 zeigt, werden die Ausbrüche 9 an der Oxidkante des Rahmens 1 gestoppt, da die Druckkräfte, die beim Sägen der Halbleiterscheibe entstehen und die beim Überschreiten eines kritischen Wertes zu mechanischer Kristallzerstörung infolge von Muschelausbrüchen (Chippage) führen, durch die Zugkräfte des thermischen Oxides des Rahmens 1 kompensiert werden.

Fig. 1 zeigt aber auch, daß bei zu großen Sägekräften im Bereich 10 die Kompensation der beim Sägen auftretenden Druckkräfte durch die Zugkräfte des thermischen Oxides nicht ausreicht und ein großer Ausbruch entsteht. Derartige große Sägekräfte treten aber unter normalen Sägebedingungen nicht auf und entstehen nur bei ungeeigneter Sägeeinstellung bzw. bei schlecht gedresstem Sägeblatt.

Infolge des Chippage-Stopper-Rahmens 1 kann die Sägespurbreite im Sägebereich 7 verkleinert werden, ohne die Qualität bzw. die Ausbeute der Einzelhalbleiterbauelemente zu reduzieren. Auf diese Weise kann auf der Halbleiterscheibe kostbarer Platz gespart werden und können dadurch beispielsweise pro Halbleiterscheibe mehr Halbleiterbauelemente hergestellt werden.

Fig. 2 zeigt schematisch einen Querschnitt durch eine P⁺N-Diode nach Fig. 1. Im N-dotierten Siliciumsubstrat 5 ist eine P⁺-dotierte Zone zur Erzielung eines P⁺N-Überganges für die Diode und ein N⁺-Channelstopper 4 erzeugt. Die in Fig. 2 dargestellte Diode besitzt einen Chippage-Stopper-Rahmen 1 aus Siliciumdioxid mit einer Breite von größer oder gleich 5µm, einen Sicherheitsbereich 2 zwischen dem Chippage-Stopper-Rahmen 1 und dem aktiven Bereich 3 der Diode, wobei der Sicherheitsbereich 2 wiederum vorzugsweise eine Breite von größer oder gleich 5µm aufweist. Im aktiven Bereich 3 sind die Übergänge zwischen den verschieden dotierten Zonen von einer Siliciumdioxidschicht 6 bedeckt. Der Sicherheitsbereich 2 verbessert den Schutz des aktiven Bereichs 3 gegen schädliche Wirkungen.

Der Chippage-Stopper-Rahmen 1 auf dem Halbleitersubstrat 5 ist nur dann sinnvoll, wenn in der Mitte 8 im Sägebereich 7 zwischen zwei Einzelhalbleiterbauelementechips insbesondere in der Nähe der Kanten der Chippage-Stopper-Rahmen 1 der benachbarten Einzelhalbleiterbauelementechips an der Oberfläche des Halbleitersubstrats 5 im Sägebereich 7 ein symmetrisches Zugspannungsfeld entsteht. Dieses symmetrische Zugspannungsfeld in der Mitte 8 des Sägebereichs 7 entsteht beispielsweise dadurch, daß der Chippage-Stopper-Rahmen in einer ganz besonderen Art und Weise auf das Halbleitersubstrat 5 aufgebracht wird. Der Chippage-Stopper-Rahmen 1 muß zu diesem Zweck nicht aus thermischem Oxid bestehen. Der Chippage-Stopper-Rahmen 1 kann auch aus einer CVD-Oxid- oder aus einer Nitridschicht bestehen, wenn die Abscheideparameter so gewählt werden, daß im Sägebereich 7 ein symmetrisches Zugspannungsfeld entsteht, das die beim Sägen entstehenden Druckkräfte kompensiert. Zu diesem Zweck kann beispielsweise ein Chippage-Stopper-Rahmen 1 bei erhöhter Temperatur aufgebracht und zusammen mit dem Halbleitersubstrat abgekühlt werden. Wenn der lineare Ausdehnungskoeffizient des Chippage-Stopper-Rahmens größer ist als der lineare Ausdehnungskoeffizient des Halbleitersubstrats, kann der Chippage-StopperRahmen auch bei erniedrigter Temperatur auf das Halbleitersubstrat aufgebracht werden. Der Chippage-Stopper-Rahmen kann auch bei Normaltemperatur aufgebracht werden, wenn das Sägen beispielsweise bei tieferer oder auch bei höherer Temperatur erfolgt, je nach Konstellation der Ausdehnungskoeffizienten. Wichtig für die Erfindung ist, daß eine Differenz in den linearen Ausdehnungskoeffizienten von Halbleitersub-strat und Chippage-Stopper-Rahmen 1 dahingehend ausgenutzt wird, daß durch Variation von Temperatur und physikalischen oder chemischen Vorgängen im Halbleiterkristall im Sägebereich 7 ein symmetrisches Zugspannungsfeld entsteht.

Der Chippage-Stopper-Rahmen 1 kann in beliebiger Weise in den technologischen Aufbau eines Halbleiterbauelements, der natürlich auch eine integrierte Schaltung umfassen kann, integriert werden. Beispielsweise können oberhalb des Chippage-Stopper-Rahmens 1 weitere Schichten wie beispielsweise Phosphor-Silikat-Glas, Nitrid, Aluminium, usw. aufgebracht werden. Diese weiteren Schichten sind ohne Einfluß auf die Wirkungsweise des Chippage-Stopper-Rahmens.

Der Rahmen 1 muß nicht den Rand eines späteren Einzelteils auf der Halbleiterscheibe durchgehend vollständig umgeben. Zur Erzielung einer symmetrischen Zugspannung im Sägebereich 7 kann es bereits genügen, wenn der Rahmen 1 auch nur abschnittsweise am Rand eines späteren Einzelteils auf der Halbleiterscheibe vorhanden ist.

Wichtig für die Erfindung ist, daß der Chippage-Stopper-Rahmen 1 bei einer Temperatur auf die Halbleiterscheibe aufgebracht wird, die verschieden von derjenigen Temperatur ist, bei der die Halbleiterscheibe gesägt wird.

## Ansprüche

1. Verfahren zum Begrenzen von Ausbrüchen beim Sägen einer Halbleiterscheibe in aktive Bereiche (3) enthaltende Einzelteile, die zumindest bereichsweise eine dielektrische Schicht aufweisen, bei dem jeweils an den Berandungen von späteren Einzelteilen auf die Oberfläche der Halbleiterscheibe zwischen einem Sägebereich (7) und einem neben dem aktiven Bereich (3) liegenden Schutzbereich (2) Rahmen (1) aus der dielektrischen Schicht so aufgebracht werden, daß diese Rahmen (1) aus der dielektrischen Schicht auf die Halbleiteroberfläche eine Zugspannung ausüben, wodurch im Sägebereich (7) an der Oberfläche der Halbleiterscheibe ein symmetrisches Zugspannungsfeld entsteht zum Begrenzen von Ausbrüchen (9) des Halbleitermaterials, wobei beim Aufbringen des Rahmens (1) auf die Halbleiterscheibe und beim Sägen der Halbleiterscheibe unterschiedliche Temperaturen verwendet werden.

2. Verfahren nach Anspruch 1, **dadurch gekennzeichnet**, daß als dielektrische Schicht thermisches Oxid aufgebracht wird.

3. Verfahren nach Anspruch 1 oder 2, **dadurch gekennzeichnet**, daß als dielektrische Schicht eine Oxidschicht abgeschieden wird.

4. Verfahren nach einem der Ansprüche 1 bis 3, **dadurch gekennzeichnet**, daß als dielektrische Schicht eine Nitridschicht abgeschieden wird.

5. Verfahren nach einem der Ansprüche 1 bis 4, **dadurch gekennzeichnet**, daß das Aufbringen der dielektrischen Schicht bei erhöhter Temperatur erfolgt.

6. Verfahren nach einem der Ansprüche 1 bis 5, **dadurch gekennzeichnet**, daß der Rahmen (1) bei erhöhter Temperatur aufgebracht und zusammen mit der Halbleiterscheibe abgekühlt wird.

7. Verfahren nach einem der Ansprüche 1 bis 6, **dadurch gekennzeichnet**, daß der Rahmen (1) eine Breite in der Größenordnung von 1μm und eine Dicke in der Größenordnung von 0,1μm hat.

## Claims

1. Method for limiting chippage when sawing a semi-conductor wafer into individual pieces which contain active regions (3) and which have, at least in certain regions, a dielectric layer, in which method in each case frames (1) of the dielectric layer are applied to the surface of the semi-conductor wafer at the borders of later individual pieces, between a sawing region (7) and a protective region (2) lying near to the active region (3), in such a way that these frames (1) of the dielectric layer exert a tensile stress on the semi-conductor surface, as a result of which a symmetrical tensile stress field arises in the sawing region (7) at the surface of the semi-conductor wafer for limiting chippage (9) of the semi-conductor material, different temperatures being used when applying the frame (1) to the semi-conductor wafer and when sawing the semi-conductor wafer.

2. Method according to Claim 1, characterized in that thermal oxide is applied as dielectric layer.

3. Method according to Claim 1 or 2, characterized in that an oxide layer is deposited as dielectric layer.

4. Method according to one of Claims 1 to 3, characterized in that a nitride layer is deposited as dielectric layer.

5. Method according to one of Claims 1 to 4, characterized in that the application of the dielectric layer is performed at an elevated temperature.

6. Method according to one of Claims 1 to 5, characterized in that the frame (1) is applied at an elevated temperature and is cooled together with the semiconductor wafer.

7. Method according to one of Claims 1 to 6, characterized in that the frame (1) has a width of the order of magnitude of 1μm and a thickness of the order of magnitude of 0.1μm.

## Revendications

1. Procédé pour limiter des ébréchures lors du sciage d'une pastille semiconductrice pour l'obtention d'éléments individuels, qui contiennent des zones actives (3) et comportent au moins par endroits une couche diélectrique, et selon lequel on dépose des cadres (1) formés de la couche diélectrique sur la surface de la pastille semiconductrice, au niveau des bords d'éléments individuels formés ultérieurement, entre une zone de sciage (7) et une zone de protection (2) située à côté de la zone active (3), que ces cadres (1) formés par la couche diélectrique exercent sur la surface semiconductrice une contrainte de traction qui fait apparaître, dans la zone de sciage (7), au niveau de la surface de la pastille semiconductrice, un champ symétrique de contraintes de traction servant à limiter des ébréchures (9) du matériau semiconducteur, et, lors du dépôt du cadre (1) sur la pastille semiconductrice et lors du sciage de cette pastille, on utilise des températures différentes.

2. Procédé suivant la revendication 1, caractérisé par le fait qu'on dépose un oxyde thermique en tant que couche diélectrique.

3. Procédé suivant la revendication 1 ou 2, caractérisé par le fait qu'on dépose une couche d'oxyde en tant que couche diélectrique.

4. Procédé suivant l'une des revendications 1 à 3, caractérisé par le fait qu'on dépose une couche de nitrure en tant que couche diélectrique.

5. Procédé suivant l'une des revendications 1 à 4, caractérisé par le fait que le dépôt de la couche diélectrique est réalisé à une température accrue.

6. Procédé suivant l'une des revendications 1 à 5, caractérisé par le fait qu'on dépose le cadre (1) à une température accrue et qu'on le refroidit en même temps que la pastille semiconductrice.

7. Procédé suivant l'une des revendications 1 à 6, caractérisé par le fait que le cadre (1) possède une largeur de l'ordre de 1 μm et une épaisseur de l'ordre de 0,1 μm.

# FIG 1

# FIG 2